# EUROPEAN PATENT APPLICATION

(11) **EP 4 517 799 A1**
(43) Date of publication of application: **05.03.2025**
(21) Application number: 23796016.6
(22) Date of filing: 03.04.2023
(51) Int. Cl.: H01L 21/3065

(54) **PLASMA PROCESSING METHOD AND PLASMA PROCESSING APPARATUS**

(30) Priority: 26.04.2022 JP 2022072537
(71) Applicant: Samco Inc., Kyoto-shi, Kyoto 612-8443 (JP)
(72) Inventor: TSUMAYA, Madoka, Kyoto-shi, Kyoto 612-8443 (JP); TERAI, Hirokazu, Kyoto-shi, Kyoto 612-8443 (JP)
(74) Representative: DTS Patent- und Rechtsanwälte PartmbB
(86) International application number: PCT/JP2023/013830
(87) International publication number: WO 2023/210269

(57) **Abstract**

Provided is a plasma processing method capable of providing, in plasma processing of an electronic device substrate in which a semiconductor substrate having a copper film on a surface is etched using a photoresist and plating processing is performed, effects of (1) chemical reduction of the copper film, (2) high-speed ashing of the photoresist, and (3) hydrophilization of an inner surface of a via. The plasma processing method for plating processing of an electronic device substrate according to the present invention includes: a) a step of disposing the electronic device substrate such as a semiconductor substrate, a lead frame, or the like in a processing chamber; b) a step of supplying a source gas consisting of hydrogen and water vapor to the processing chamber, the source gas being obtained from a water electrolysis apparatus; and c) a step of subjecting the electronic device substrate to plasma processing by converting the source gas in the processing chamber into plasma.

## Description

### TECHNICAL FIELD

The present invention relates to a plasma processing method performed for cleaning a surface of an electronic device substrate such as a semiconductor substrate, a lead frame, and the like, and further relates to an apparatus for the plasma processing method.

### BACKGROUND ART

With the development of the information society, semiconductor packages have been enhanced in performance, functionality, and downsizing. Semiconductor chips can be connected at high density by using a flip chip mounting technology, and micro-bumps using copper (Cu) posts are widely used in order to cope with increasing requirements for electrical characteristics, an increase in the number of I/Os, and the problem of an increase in gold price.

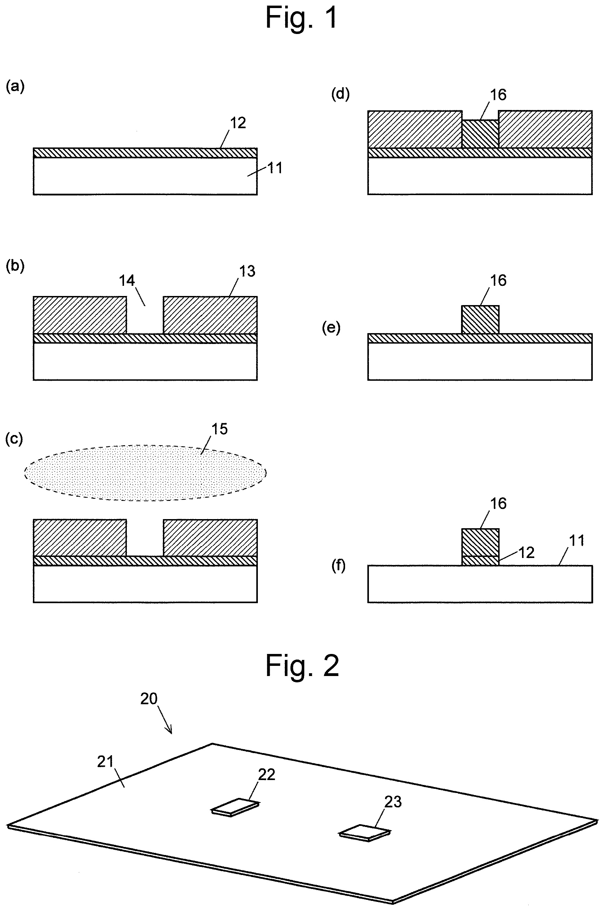

In many cases, a micro-bump is formed as shown in Fig. 1(a)-(f) (Non Patent Literature 1). First, a photoresist 13 is applied to a substrate 11 (Fig. 1(a)) coated with a copper film 12, and a via (opening) 14 is formed in a portion of wiring of the substrate (Fig. 1(b)). At this point, pre-processing is performed with plasma 15 to clean the inside and the periphery of the via 14 (Fig. 1(c)). Then, the via 14 is filled with copper 16 by plating (Fig. 1(d)). Subsequently, the photoresist 13 is removed (Fig. 1(e)), and the copper film 12 on the substrate 11 is removed (Fig. 1(f)).

### CITATION LIST

### PATENT LITERATURE

Patent Literature 1: JP H06-029254 A
Patent Literature 2: JP 2018-098353 A
Patent Literature 3: JP 2015-160192 A

### NON PATENT LITERATURE

Non Patent Literature 1: "Application of Aqua Plasma (Registered Trademark) to Microbumps", samco NOW Vol. 111, October 2020, Samco Inc.

### SUMMARY OF INVENTION

### TECHNICAL PROBLEM

When the via is cleaned in the process of copper micro-bump forming, it is necessary to obtain the effects of (1) preventing oxidation of the copper film or reducing the oxidized copper film at the bottom portion (on the substrate), (2) ashing of photoresist residues, and (3) hydrophilizing the inner surface of the via to make it easy for a plating solution to enter. In the conventional processing of a semiconductor substrate using plasma (for example, Patent Literature 1), by performing hydrogen plasma processing in a specific chamber, the effect of (1) preventing oxidation of the copper film or reducing the oxidized copper film has been obtained, but a sufficient effect has not been obtained for (2) ashing of photoresist residues and (3) hydrophilizing the inner surface of the via.

Such effects of (1) to (3) (in case of (2), achieving a sufficient ashing speed) are commonly required not only in forming micro-bumps but also in pre-processing in the case of etching a semiconductor substrate having a copper film on the surface using a photoresist and plating processing. In the conventional mounting technology in which a lead portion (lead frame) and an electrode portion (hereinafter, referred to as metal portion) of the semiconductor substrate are connected by a metal wire, it is necessary to similarly prevent oxidation or reduce the oxidation of the lead portion and the electrode portion.

The present invention has been made to solve such problems of the related art, and an object of the present invention is to provide a plasma processing method capable of providing the effects of (1) to (3) when processing such a semiconductor substrate, an electronic device substrate including a metal portion, a lead portion, and the like.

### SOLUTION TO PROBLEM

A plasma processing method for an electronic device substrate according to the present invention made to solve the above problems includes:
a) a step of disposing the electronic device substrate in a processing chamber;
b) a step of supplying a source gas consisting of hydrogen and water vapor to the processing chamber, the source gas being obtained from a water electrolysis apparatus; and
c) a step of subjecting the electronic device substrate to plasma processing by converting the source gas in the processing chamber into plasma.

Here, the electronic device substrate includes, in addition to the semiconductor substrate, a metal portion such as an electrode of the semiconductor substrate, a lead portion such as a peripheral lead frame, and the like. Regarding the source gas, it is preferable that the water vapor in the entire source gas has an amount equal to or more than the saturation state of water in the source gas. For example, the water vapor is about 3.3 pressure% or more at 27 °C. Furthermore, it is preferable that the water vapor is 10 to 40 pressure%.

A plasma processing apparatus for plating processing of an electronic device substrate according to the present invention made to solve the above problems includes:
a) a processing chamber provided with a mounting table for an electronic device substrate to be processed;
b) a water electrolysis apparatus to be connected to the processing chamber, the water electrolysis apparatus being a supply source of a source gas consisting of hydrogen and water vapor; and
c) a plasma generation section configured to convert the source gas introduced into the processing chamber into plasma.

### ADVANTAGEOUS EFFECTS OF INVENTION

According to the method of the present invention, in the plasma processing of an electronic device substrate, the following effects can be reliably obtained: (1) preventing oxidation of the copper film or reducing the oxidized copper film on the substrate; (2) high-speed ashing of photoresist residues; and (3) hydrophilizing the surface to make it easy for a plating solution to enter a narrow space.

### BRIEF DESCRIPTION OF DRAWINGS

[Fig. 1] Explanatory views illustrating a procedure for forming a micro-bump.
[Fig. 2] A view illustrating a sample set in which a copper oxide chip and a silicon chip are placed on a dummy substrate.
[Fig. 3] Schematic configuration diagrams of a plasma processing apparatus used in tests performed to confirm the effects of the present invention.
[Fig. 4] Emission intensity graphs showing a result of optical emission spectroscopy of plasma performed at the time of plasma processing.
[Fig. 5] A table showing the contents of each test performed to confirm the effects of the present invention.
[Fig. 6] A table showing results of First Test and Second Test.
[Fig. 7] A table showing results of Third Test.

### DESCRIPTION OF EMBODIMENTS

Hereinafter, methods and results of tests performed to confirm the effects of the present invention will be described with reference to the drawings.

### [Samples]

The samples subjected to the tests are the following two kinds.

### (1) Copper oxide chip

The copper oxide chip, which is a copper plate of 10 × 20 × 0.3 mm having an oxidized surface where an oxidized copper film has a thickness of 40 nm.

### (2) Silicon chip

The silicon chip, which is a silicon (Si) plate of 15 × 15 × 0.5 ± 0.025 mm having a surface to which photoresist (PR) is applied, PR being THMR-IP3250 manufactured by TOKYO OHKA KOGYO CO., LTD., baked product at 110 °C × 5 min, with the coating thickness of 1 µm.

In Third Test described later, these chips were placed on the following dummy substrate.

### (3) Dummy substrate

The dummy substrate, which is a pure copper plate of 200 × 150 × 0.3 mm, the substrate assuming a 300 mm (ϕ8) wafer.

Fig. 2 illustrates a sample set 20 in which a copper oxide chip 22 and a silicon chip 23 are placed on a dummy substrate 21.

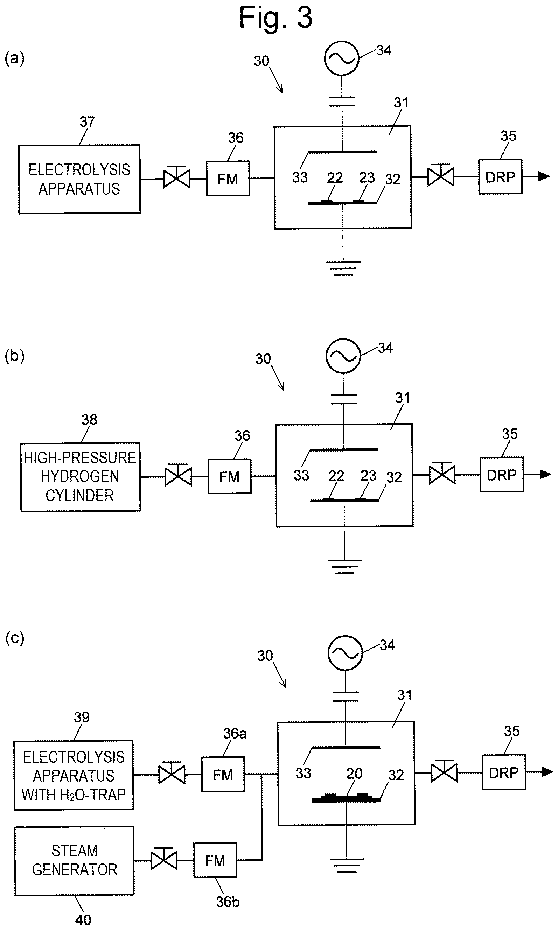

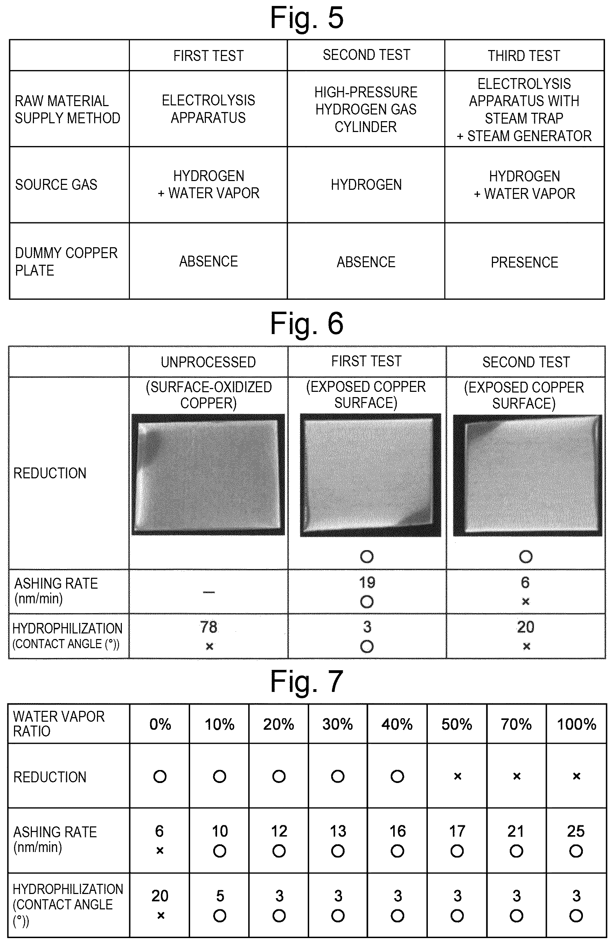

As a plasma processing apparatus, a parallel plate type plasma processing apparatus (PD-220) 30 manufactured by Samco Inc. was used. As shown in Fig. 3(a)-(c), the plasma processing apparatus 30 is used with a lower electrode 32 grounded and an upper electrode 33 (having an area of 452 m²) connected to a radio-frequency power supply 34 (PE mode). Then, a processing chamber 31 was connected to a vacuum pump (DRP) 35 and connected to a plasma gas source via a flow meter (FM) 36. A different plasma gas source was used for each test. The contents are shown in the table of Fig. 5. The processing chamber 31 is made of metal (stainless steel).

The methods and results of each test are as follows. The methods are summarized in Fig. 5, and the results are summarized in Figs. 6 and 7.

### <First Test>

In First Test, as shown in Fig. 3(a), an electrolysis apparatus 37 was used as a plasma gas source. If a high-pressure hydrogen cylinder is used as a plasma gas source, it is necessary to perform installation and maintenance under the regulations of the High Pressure Gas Safety Act, and thus the electrolysis apparatus 37 is used in the present invention. In the electrolysis apparatus 37, water is electrolyzed to generate and output hydrogen, and at the same time, water (water vapor) is also output. Since water is output in a state of a substantially saturated water vapor pressure, the water of about 3.3 pressure% is contained in the output gas at room temperature (27 °C).

When hydrogen is produced by the electrolysis apparatus 37, water containing a small amount of sodium hydroxide (NaOH) can be used as a raw material in addition to pure water. Accordingly, the electrolysis of water is more efficiently performed. However, when water containing a small amount of sodium hydroxide is used, a source gas mixed with a small amount of Na is supplied to the processing chamber, and the inside of the processing chamber and the surface of the substrate may be contaminated with Na. Therefore, it is preferable to use pure water as a raw material, and in this respect, an electrolysis apparatus including a solid electrolyte cell is preferable.

The copper oxide chip 22 and the silicon chip 23 were placed on the lower electrode 32, and the inside of the processing chamber 31 was evacuated by the vacuum pump 35. Subsequently, hydrogen containing water vapor was fed from the electrolysis apparatus 37 into the processing chamber 31. At a pressure of 5 Pa, radio-frequency power was input from the radio-frequency power supply 34 while the source gas (hydrogen + water vapor) was caused to flow at a flow rate of 20 SCCM. The input radio-frequency power was 100 W, and the processing time was 3 min.

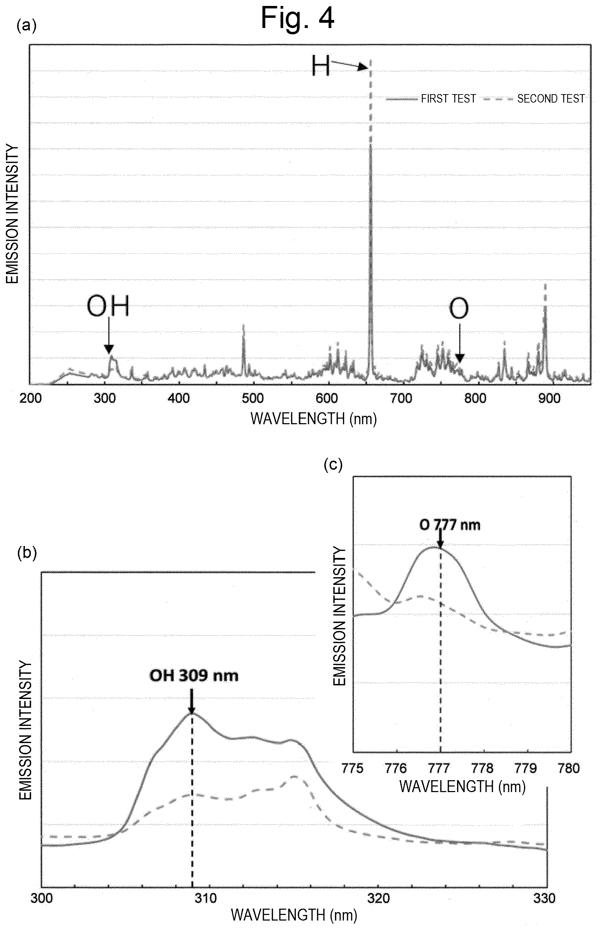

Fig. 4(a) shows the results of optical emission spectroscopy of the plasma during the processing (solid line). In addition to the presence of a high peak of H (hydrogen) at 656 nm, a peak of OH (hydroxy radical) at 309 nm due to water vapor was observed at a height twice as high as that in Second Test described later, and a peak of O (oxygen) at 777 nm was observed at a height 1.5 times as high as that in Second Test (Fig. 4(b)-(c)). OH (hydroxyl group) contributes to improvement in hydrophilization of the surface, and O (oxygen) contributes to improvement in ashing speed of PR.

When the surface of the copper oxide chip 22 was observed after the plasma processing, the copper oxide was completely reduced, and the pure copper surface was exposed (upper center column in Fig. 6).

Next, the ashing rate was calculated by dividing the thickness (1 µm) of the photoresist (PR) on the surface of the silicon chip 23 by the processing time to be 19 nm/min (middle center column in Fig. 6).

Furthermore, a water contact angle of the surface (photoresist layer) of the silicon chip 23 after the plasma processing was measured. The water contact angle is defined as hydrophilic at 90° or less, and super hydrophilic at 10° or 5° or less. As a result of the measurement, the water contact angle was 3°, and super hydrophilization was observed (lower center column in Fig. 6).

### <Second Test>

In Second Test, as shown in Fig. 3(b), a high-pressure hydrogen cylinder 38 storing high-purity hydrogen was used as a plasma gas source instead of using the electrolysis apparatus. The purity of hydrogen supplied from the high-pressure hydrogen cylinder 38 is 99.9999% or more.

Similarly to First Test, the copper oxide chip 22 and the silicon chip 23 were placed on the lower electrode 32, and the inside of the processing chamber 31 was evacuated by the vacuum pump 35. Subsequently, high-purity hydrogen was fed from the high-pressure hydrogen cylinder 38 into the processing chamber 31. Similarly to First Test, radio-frequency power was input from the radio-frequency power supply 34 while the source gas (hydrogen) was caused to flow at a pressure of 5 Pa and a flow rate of 20 SCCM. As in First Test, the input radio-frequency power was 100 W, and the processing time was 3 min.

The result of the optical emission spectroscopy of the plasma during the processing is as indicated by the broken line in Fig. 4(a). No clear peak was observed for OH at 309 nm or O at 777 nm attributable to water vapor (Fig. 4(b)-(c)).

When the surface of the copper oxide chip 22 was observed after the plasma processing, the copper oxide was completely reduced, and the pure copper surface was exposed (upper right column in Fig. 6).

In Second Test, the ashing rate was 6 nm/min (middle right column in Fig. 6).

In addition, the water contact angle was 20° (lower right column in Fig. 6).

### <Third Test>

In Third Test, as shown in Fig. 3(c), a hydrogen gas source and a water vapor source were used in combination as a plasma gas source, a hydrogen gas source obtained by adding a steam trap apparatus (H₂O-TRAP) to the electrolysis apparatus 37 (electrolysis apparatus 39 with H₂O-TRAP) was used as a hydrogen gas source, and a heating vaporization type steam generator 40 was used as a water vapor source. The flow rates of the hydrogen gas and the water vapor were adjusted by flow meters 36a and 36b, respectively, and plasma processing was performed by changing the mixing ratio of the hydrogen gas and the water vapor from 0% to 100% by 10%.

In Third Test, in order to approximate the actual processing environment of the wafer, the copper oxide chip 22 and the silicon chip 23 were set on the lower electrode 32 as a sample set 20 placed on the pure copper dummy substrate 21 as shown in Fig. 2. Plasma processing conditions are the same as in First Test and Second Test.

When the surface of the copper oxide chip 22 was observed when the plasma processing was performed at each mixing ratio of hydrogen/water vapor = 100/0 to 0/100, as shown in the second row of Fig. 7, the copper oxide on the surface was completely reduced and the pure copper surface was exposed under the condition of hydrogen/water vapor = 100/0 to 60/40, but the surface was not completely reduced under the condition of hydrogen/water vapor = 50/50 to 0/100 (in Fig. 7, the results of hydrogen/water vapor = 40/60, 20/80, and 30/90 are omitted).

The ashing rate of the photoresist layer under each condition is as shown in the third row of Fig. 7. Under the condition of hydrogen/water vapor = 100/0, the value of the ashing rate was slightly low, but under the condition of hydrogen/water vapor = 90/10 to 0/100, the photoresist layer was removed at a sufficiently high speed.

The water contact angle of the photoresist layer after the processing under each condition is as shown in the fourth row of Fig. 7. Also here, under the condition of hydrogen/water vapor = 100/0, the value of the water contact angle is 20°, which is slightly large, but under the condition of hydrogen/water vapor = 90/10 to 0/100, the water contact angle is 5 to 3°, which is super hydrophilized.

### <Summary>

Comparing First Test in which the source gas was hydrogen + water vapor with Second Test in which the plasma source gas was only hydrogen (Figs. 3(a)-(b) and 5), there was no difference in the effect of reducing copper oxide (the second row of Fig. 6), but in First Test in which hydrogen + water vapor was used as the source gas, a value higher than that of Second Test in which only hydrogen was used as the source gas was obtained at the photoresist layer removal speed (ashing rate) (the third row of Fig. 6). In addition, regarding hydrophilization of the surface of the photoresist layer, in First Test using hydrogen + water vapor as a source gas, a high hydrophilization effect was obtained (the fourth row of Fig. 6). From this, it has become clear that, by performing etching using a photoresist on a semiconductor substrate having a copper film on the surface and performing plasma processing using a source gas consisting of hydrogen and water in pre-processing in the case of plating processing, it is possible to obtain each effect of (1) preventing oxidation of the copper film or reducing the oxidized copper film, (2) ashing of photoresist residues, and (3) hydrophilizing the surface of the photoresist layer such as the inside of a via and making it easy for a plating solution to enter. Such plasma processing is also effective in a case where it is necessary to prevent oxidation or reduce the oxidation of a metal portion such as a lead portion (lead frame), an electrode, and the like in a mounting technology in which the lead portion and the electrode portion of the semiconductor substrate are connected by a metal wire.

When hydrogen + water vapor is used as the source gas in the plasma processing of the substrate, water vapor inevitably mixed in hydrogen gas generated by the electrolysis apparatus can be used as it is by using the electrolysis apparatus as performed in First Test. When a high-pressure hydrogen cylinder is used as a hydrogen gas source, it is necessary to prepare a predetermined facility and dispose a qualified person according to laws and regulations such as the High Pressure Gas Safety Act, and thus a practical hurdle is high, but such a problem can be avoided by using an electrolysis apparatus.

When the source gas is hydrogen + water vapor, it is preferable that the ratio of water vapor is 10 to 40% according to the result of Third Test. When the ratio of water vapor in the source gas is 10% or more (more precisely, a pressure of about 3.3% or more, which is the saturated vapor pressure of water) as described above, the hydrogen gas (including water vapor having a saturated vapor pressure) generated by the electrolysis apparatus as described above is insufficient, and thus it is necessary to prepare a steam generator separately from the hydrogen gas source and additionally supply water vapor generated by the steam generator.

The inventor has proposed a plasma processing method in which a mixed gas of water vapor and oxygen or a mixed gas of oxygen and hydrogen is converted into plasma to perform reduction processing of copper oxide or silver oxide (Patent Literature 2 and Patent Literature 3), but an electrolysis apparatus can also be used as a generation source of these mixed gases.

### REFERENCE SIGNS LIST

11... Substrate
12... Copper film
13... Photoresist
14... Via
15... Plasma
16... Copper
20... Sample Set
21... Dummy Substrate
22... Copper Oxide Chip
23... Silicon Chip
30... Plasma Processing Apparatus
31... Processing Chamber
32... Lower Electrode
33... Upper Electrode
34... Radio-frequency Power Supply
35... Vacuum Pump
36, 36a, 36b... Flow Meter
37... Electrolysis Apparatus
38... High-pressure Hydrogen Cylinder
39... Electrolysis Apparatus with Steam Trap Apparatus
40... Steam Generator

## Claims

1. A plasma processing method for an electronic device substrate, the method comprising:
a) a step of disposing the electronic device substrate in a processing chamber;
b) a step of supplying a source gas consisting of hydrogen and water vapor to the processing chamber, the source gas being obtained from a water electrolysis apparatus; and
c) a step of subjecting the electronic device substrate to plasma processing by converting the source gas in the processing chamber into plasma.

2. The plasma processing method for an electronic device substrate according to claim 1, wherein water vapor is further supplied into the processing chamber to set a mixing ratio of the source gas to hydrogen/water vapor = 90/10 to 60/40.

3. The plasma processing method for an electronic device substrate according to claim 1 or 2, wherein the water electrolysis apparatus does not include a steam trap apparatus.

4. The plasma processing method for an electronic device substrate according to claim 1 or 2, wherein the electronic device substrate has a photoresist layer and a copper film on a surface of the electronic device substrate.

5. A plasma processing apparatus comprising:
a) a processing chamber provided with a mounting table for an electronic device substrate to be processed;
b) a water electrolysis apparatus to be connected to the processing chamber, the water electrolysis apparatus being a supply source of a source gas consisting of hydrogen and water vapor; and
c) a plasma generation section configured to convert the source gas introduced into the processing chamber into plasma.

6. The plasma processing apparatus according to claim 5, wherein the water electrolysis apparatus does not include a steam trap apparatus.
